**Europäisches Patentamt**

**European Patent Office**

**Office européen des brevets**

(19)

(11) Veröffentlichungsnummer : **0 111 263**
**B1**

(12)

# EUROPÄISCHE PATENTSCHRIFT

(45) Veröffentlichungstag der Patentschrift :
**04.03.87**

(51) Int. Cl.⁴ : **G 02 B   6/42**

(21) Anmeldenummer : **83112092.8**

(22) Anmeldetag : **01.12.83**

(54) **Sende- oder Empfangsvorrichtung mit einer mittels eines Trägers gehalterten Diode.**

(30) Priorität : **03.12.82 DE 3244882**

(43) Veröffentlichungstag der Anmeldung :
**20.06.84 Patentblatt 84/25**

(45) Bekanntmachung des Hinweises auf die Patenterteilung : **04.03.87 Patentblatt 87/10**

(84) Benannte Vertragsstaaten :
**AT BE CH DE FR GB IT LI NL SE**

(56) Entgegenhaltungen :
**CA-A- 1 108 900**
**GB-A- 2 053 563**
**GB-A- 2 065 918**
**PATENTS ABSTRACTS OF JAPAN, Band 4, Nr. 51, 17. April 1980, Seite 125P7**

(73) Patentinhaber : **Siemens Aktiengesellschaft Berlin und München**
**Wittelsbacherplatz 2**
**D-8000 München 2 (DE)**

(72) Erfinder : **Falkenstein, Rudolf, Dipl.-Phys.**
**Kulischstrasse 10**
**D-8050 Freising (DE)**
Erfinder : **Taumberger, Franz**
**Stiftsbogen 118**
**D-8000 München 70 (DE)**
Erfinder : **Trommer, Reiner, Dr. Dipl.-Phys.**
**Scherbaumstrasse 9b**
**D-8000 München 83 (DE)**

**Beschreibung**

Die Erfindung bezieht sich auf eine Sende- oder Empfangsvorrichtung mit einer mittels eines Trägers gehalterten Sende- oder Empfangs-Diode und mit einem mit einem optischen Fenster der Diode optisch gekoppelten Lichtwellenleiter, wobei der Träger mit einer Ausnehmung zur Durchführung des Lichtwellenleiters versehen ist und die Diode derart auf den Träger aufgesetzt ist, daß sich das optische Fenster der Diode an der Ausnehmung befindet.

Eine derartige Empfangsvorrichtung ist bereits aus Electronics Letters, Vol. 17, Nº 22, Seite 832 bekannt. Bei der bekannten Empfangsvorrichtung ist die Empfangsdiode auf einem Keramikblock angebracht, der ein kleines Loch zur Aufnahme der Glasfaser besitzt. Nach Positionierung der Diode über dem Loch wird die Glasfaser in den Block eingeführt.

Eine PIN-Fotodiode, die eine ringförmige, ein kreisflächenförmiges Fenster umschließende Kathoden-Anschlußfläche aufweist und dem optischen Fenster gegenüberliegend eine Anoden-Anschlußfläche hat, ist bereits aus Siemens Forschungs- und ' Entwicklungsberichte, Band 11 (1982), Nr. 4, Seiten 204 bis 208 und 216 bis 220 bekannt.

Aufgabe der Erfindung ist es, eine Empfangsvorrichtung der eingangs genannten Art derart auszubilden, daß sich ein Lichtwellenleiter vor dem Fenster der PIN-Fotodiode auf möglichst einfach realisierbare Weise exakt justieren und anschließend fixieren läßt.

Gemäß der Erfindung wird die Sende- oder Empfangsvorrichtung zur Lösung dieser Aufgabe derart ausgebildet, daß der Träger mit einem Schaltungsmodul mechanisch verbunden ist und daß der Lichtwellenleiter über eine ebenfalls auf dem Schaltungsmodul angebrachte Fixiervorrichtung und durch die Ausnehmung an das optische Fenster geführt und derart fixiert ist, daß die Stirnseite des Lichtwellenleiters einen vorgegebenen Abstand vom optischen Fenster aufweist und daß die Ausnehmung konisch ausgebildet ist und daß sich die Diode auf derjenigen Seite des Trägers befindet, die die größere der beiden Stirnflächen der konischen Ausnehmung aufweist.

Durch diese Maßnahmen ergibt sich eine besonders einfach realisierbare Justierung des Lichtwellenleiters in bezug auf die Diode. Dabei wird eine Beschädigung der Endfläche der Glasfaser, die beim Justieren durch ein seitliches Verschieben auftreten könnte, vermieden.

Zweckmäßigerweise wird der Lichtwellenleiter nach seiner Justierung in bezug auf die PIN-Fotodiode fixiert. Zu diesem Zweck wird die Empfangsvorrichtung vorzugsweise derart ausgebildet, daß der Träger quaderförmig, insbesondere plattenförmig ausgebildet und senkrecht auf einer Grundplatte des Schaltungsmoduls befestigt ist und daß die Grundplatte auf der der PIN-Diode abgewandten Seite des Trägers einen die Fixiervorrichtung bildenden Klotz trägt, auf dem der Lichtwellenleiter mittels einer flußmittelfreien Lötverbindung fixiert ist.

Der Lichtwellenleiter wird dabei zweckmäßigerweise zunächst auf optimale Lichteinkopplung · in die PIN-Diode justiert und daran anschließend· auf der Fixiervorrichtung fixiert.

Vorzugsweise wird die Ausnehmung durch eine mittels Laserstrahlen hergestellte Bohrung gebildet.

In Weiterbildung der Erfindung wird die Empfangsvorrichtung derart ausgebildet, daß die PIN-Fotodiode eine ringförmige Kathoden-Anschlußfläche aufweist, die ein kreisflächenförmiges optisches Fenster umschließt und dem optischen Fenster gegenüberliegend eine Anoden-Anschlußfläche hat, und daß die Kathoden-Anschlußfläche mittels eines elektrisch leitenden Klebers mit einem auf dem Träger befindlichen elektrischen Leiter verbunden ist und daß die Anoden-Anschlußfläche durch eine Bondverbindung mit einem weiteren auf dem Träger befindlichen elektrischen Leiter verbunden ist.

Zweckmäßigerweise wird die Empfangsvorrichtung derart ausgebildet, daß zur mechanischen Verbindung des Trägers mit dem Schaltungsmodul vorgesehene Haltewinkel aus elektrisch leitendem Material bestehen und sowohl mit den elektrischen Leitern bzw. Leiterbahnen des Trägers als auch mit elektrischen Leitern bzw. Leiterbahnen des Schaltungsmoduls elektrisch verbunden sind. Dabei dienen die Haltewinkel in vorteilhafter Weise zugleich als elektrische Anschlußelemente für die PIN-Fotodiode.

Die Erfindung wird anhand der in den Figuren dargestellten Ausführungsbeispiele näher erläutert.

Es zeigen

Figur 1   eine Empfangsvorrichtung mit einem Schaltungsmodul und mit einer PIN-Fotodiode im Schnitt,

Figur 2   eine Draufsicht der Empfangsvorrichtung nach Fig. 1,

Figur 3   einen Ausschnitt aus der Draufsicht nach Fig. 2,

Figur 4   einen Schaltungsmodul mit senkrecht stehendem Diodenträger und

Figur 5   einen Ausschnitt aus Fig. 1 mit auf einem Schaltungsmodul stehenden Diodenträger und mit einem Klotz zur Fixierung des Lichtwellenleiters.

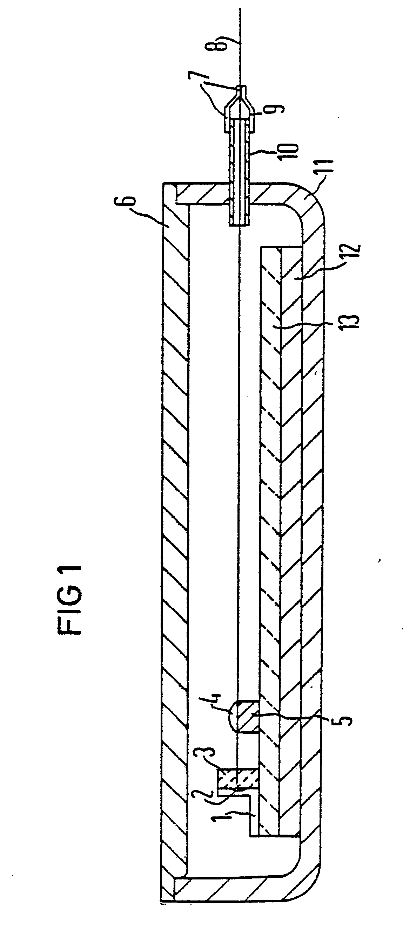

Fig. 1 zeigt den Aufbau einer Empfangsvorrichtung mit einem Empfangsmodul 13, das in einem hermetisch dichten metallenen Gehäuse 11 untergebracht ist und eine Lichtwellenleiterkopplung für die optische Übertragung aufweist. Die hermetische Kapselung ist insbesondere bei einer Verwendung ungeschützter Halbleiterchips im Schaltungsmodul zweckmäßig.

Die Empfangsvorrichtung ist in dem Metallgehäuse 11 untergebracht, das mit dem Deckel 6 verschlossen ist. Auf dem Boden des quaderförmigen Metallgehäuses 11 liegt ein Abstandsstück 12. Das Abstandsstück 12 trägt das Schaltungsmodul 13, das von plattenförmiger Gestalt ist und das in dem durch das Abstandsstück 12 vorgegebenen Abstand parallel zum Boden des Metallgehäuses 11 angeordnet ist.

In einer Seitenwand des Metallgehäuses 11 ist ein Rohr 10 angebracht, das nach außen und nach innen über die Seitenwand des Metallgehäuses 11 hinausragt. Außen ist auf das Rohr 10 das muffenförmige Verbindungsstück 9 aufgesetzt, das mit der größeren Öffnung auf das Rohr aufgesetzt ist und in dessen kleinerer Öffnung der Lichtwellenleiter 8 geführt ist. Der Lichtwellenleiter 8 verläuft durch das Verbindungsstück 9, das Rohr 10 und über einen Klotz 5 durch eine Öffnung im Diodenträger 3 zum optischen Fenster der PIN-Fotodiode 2. Der durch eine Glasfaser gebildete Lichtwellenleiter 8 ist dabei an zwei Stellen fixiert, nämlich auf dem Klotz 5 und im Innern des Verbindungsstückes 9 an der Stelle, wo das muffenförmige Verbindungsstück den kleineren Innendurchmesser hat.

Der Diodenträger 3 ist mit zwei Metallwinkeln 1 auf dem Schaltungsmodul 13 befestigt. Die beiden Metallwinkel 1, von denen in Fig. 1 nur einer sichtbar ist, befinden sich dabei neben der PIN-Diode 2.

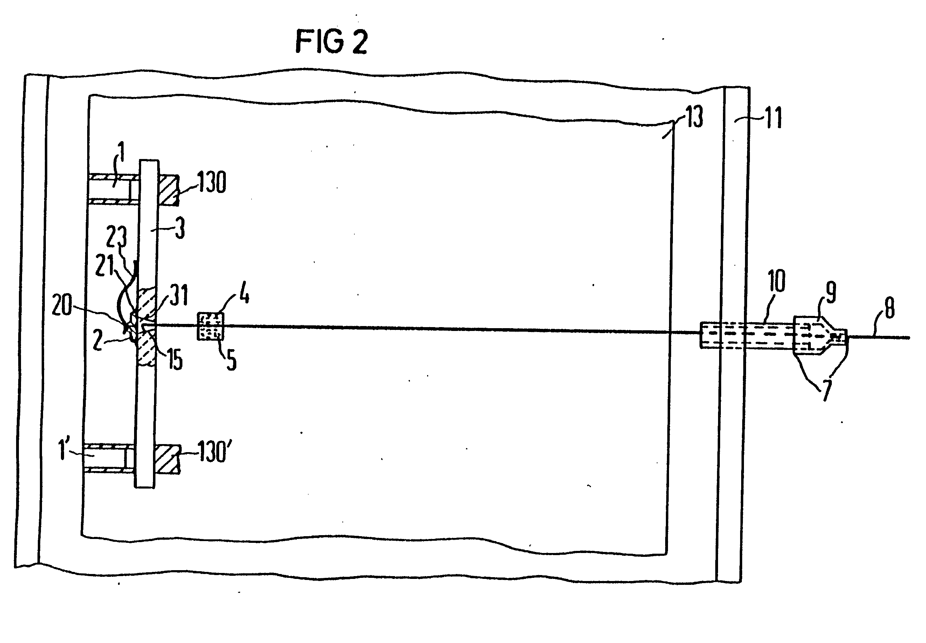

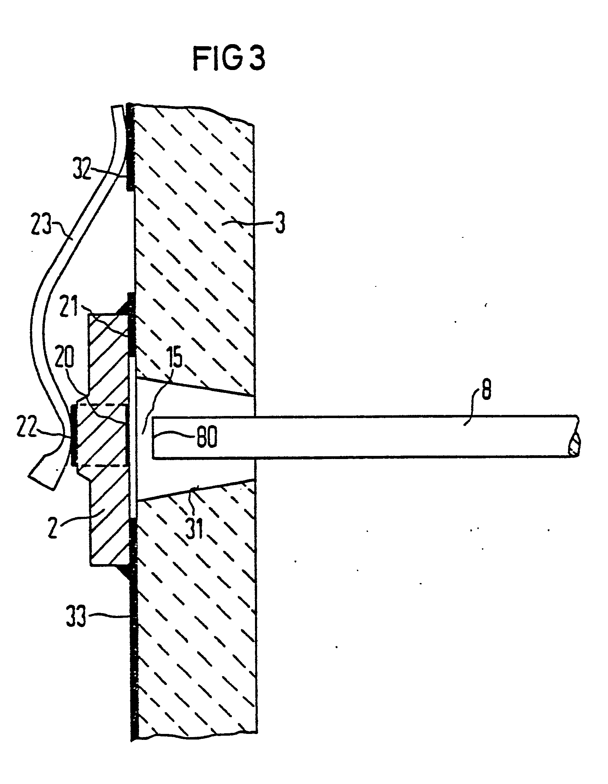

Fig. 2 zeigt eine Draufsicht der Schaltungsanordnung nach Fig. 1, wobei der Deckel des Metallgehäuses 11 geöffnet und vom Metallgehäuse selbst nur ein Teil dargestellt ist. Aus Fig. 3 geht ein Schaltungsmodul mit senkrecht stehendem Diodenträger hervor.

Der Dioden-Träger 3 hat die Gestalt einer Platte, die senkrecht auf dem Schaltungsmodul 13 steht.

Zur Befestigung des Trägers 3 auf dem Schaltungsmodul 13 dienen die beiden Haltewinkel 1 und 1', die sich auf derselben Seite des Trägers 3 befinden, wie die Diode 2. Die metallenen Haltewinkel 1 und 1' sind auf seiten des Schaltungsmoduls 13 mit den Leiterbahnen 130 und 130' verbunden. Die Leiterbahnen des Trägers 3, die die Haltewinkel 1 und 1' mit der Diode 2 verbinden, sind in der Figur nicht dargestellt. Auf den Träger 3 führt eine Leiterbahn vom Haltewinkel 1 zu einer Anschlußfläche, die über eine Bondverbindung 23 mit der Anode der Diode 2 verbunden ist. Eine weitere Leiterbahn führt vom Haltewinkel 1' zur Kathode der Diode 2.

Fig. 3 zeigt einen Ausschnitt aus Fig. 2, der nähere Einzelheiten des Dioden-Trägers 3 im Bereich der Bohrung 31 und des Aufbaus der PIN-Fotodiode 2 sowie der Kontaktierung erkennen läßt.

Die PIN-Fotodiode 2 hat an zwei einander gegenüberliegenden Flächen den kreisringförmigen n-Kontakt 21 und den zentral angeordneten kreisförmigen p-Kontakt 22. Die PIN-Fotodiode 2 hat ein optisches Fenster 20 mit einem Durchmesser von etwa 30 bis 200 μm in der Mitte der kreisringförmigen n-Kontakt 21 und gegenüber auf der Vorderseite ein Bondpad 23.

Der Lichtwellenleiter 8 ragt in die konische Bohrung bzw. Ausnehmung 31 hinein. Da sich die Ausnehmung 31 in Richtung zur Diode 2 hin erweitert, besteht in vorteilhafter Weise keine Gefahr, daß der Lichtwellenleiter 8 beim Einführen in die Ausnehmung oder beim Justieren der Innenwand anstößt und beschädigt werden kann.

Die Justierung der Glasfaser erfolgt vorzugsweise durch Justierung in allen drei Achsen des Koordinatensystems in Verbindung mit einer Messung des Fotostromes der PIN-Diode. Justiert wird dabei auf optimale Lichteinkopplung bei einer Begrenzung des Justierbereiches in achsialer Richtung der Glasfaser. Dabei kann sich im Hinblick auf die zu berücksichtigenden Toleranzen des Trägers 3 und der Klebeschicht sowie mit Rücksicht auf die zu erwartenden unterschiedlichen thermischen Ausdehnungskoeffizienten als Grenze für den Justierbereich ein minimaler Abstand der Glasfaser 8 vom Fenster 20 der Diode 2 in der Größe von etwa 10 bis 30 μm als besonders zweckmäßig erweisen.

Die Glasfaser 8 wird in der Ausnehmung 15 nicht fixiert, insbesondere nicht verklebt. Die Ausnehmung 15 ist an ihrer engsten Stelle im Durchmesser etwa 100 μm größer als die metallische Glasfaser 8, deren Durchmesser z. B. 130 μm beträgt. Die Durchmesser der Endflächen der konischen Ausnehmung unterscheiden sich insbesondere um etwa 100 μm.

Das Justieren der Glasfaser 8 am senkrecht stehenden Diodenträger 3 ist durch die besondere Ausgestaltung der Ausnehmung 31 erheblich erleichtert. Während des Justierens befindet sich der Greifer zwischen dem Träger 3 und dem Klotz 5. Die Glasfaser 8 wird dabei in vorteilhafter Weise vor dem Greifer des Mikromanipulators am Klotz 5 fixiert.

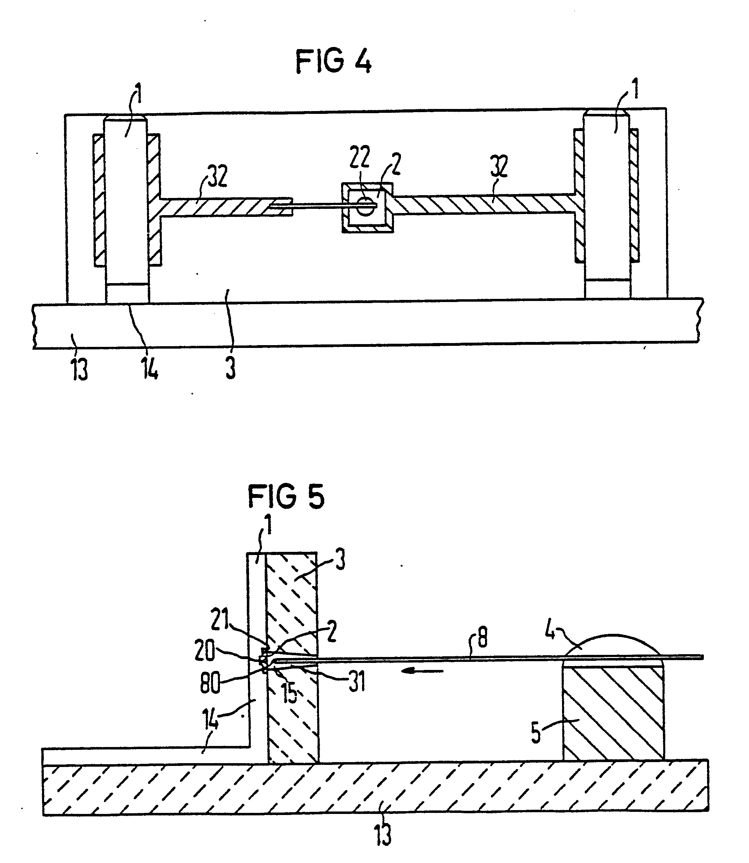

Wie aus Fig. 4 hervorgeht, ist der Diodenträger 3 von plattenförmiger Gestalt und vorzugsweise aus Keramik hergestellt. Die Figur zeigt eine Draufsicht auf die Seite des Diodenträgers, auf der die in Fig. 1 gezeigten Metallwinkel 1 angebracht werden. Die Keramikplatte ist in der Nähe ihrer Schmalseiten mit großflächen Anschlußflächen 32 und 33 versehen, von denen aus Leiterbahnen in Richtung zur Mitte des Diodenträgers 3 verlaufen. Die eine Leiterbahn umschließt die Laserbohrung 31 ; die andere Leiterbahn ist etwas kürzer, so daß eine auf die Laserbohrung aufgesetzte PIN-Fotodiode die kürzere Leiterbahn nicht berührt.

Der Diodenträger 3 besteht aus einem kleinen Substrat mit den erforderlichen Anschlüssen, das in der Mitte eine Laserbohrung 31 hat. Nach dem Anbringen der metallenen Haltewinkel 1 — vorzugsweise durch Schweißen oder Löten — wird die PIN-Diode 2 mit einem Leitkleber, der um den Rand des Loches aufgetragen wird, über die Bohrung 31 geklebt. Durch die Verwendung von elektrisch leitendem Kleber wird der Kathodenanschluß der PIN-Fotodiode 2 hergestellt. Die Anode der PIN-Fotodiode 2 wird durch die Bondverbindung 23 angeschlossen.

Die Diodenanschlüsse sind damit zugänglich, so daß eine elektrische Prüfung, insbesondere auf Dunkelstrom, ohne Schwierigkeit möglich ist. In vorteilhafter Weise kann die PIN-Diode 2 bereits nach der Montage am Diodenträger 3 elektrisch als ein Hybridbauelement geprüft werden.

Anschließend wird der Diodenträger 3 senkrecht stehend in das fertige und elektrisch vorgeprüfte Schaltungsmodul 13 geschweißt und gelötet.

Im nächsten Schritt des Herstellungsverfahrens wird bei der in Fig. 5 gezeigten Empfangsvorrichtung der Lichtwellenleiter 8 an die PIN-Fotodiode 2 angekoppelt. Dazu wird die Glasfaser 8 mit Hilfe eines Mikromanipulators soweit in die Ausnehmung 31 eingeführt, daß sie einen vorgegebenen Abstand zum optischen Fenster der PIN-Fotodiode 2 hat. In dieser Lage wird die Glasfaser 8 auf eine optimale Lichteinkopplung justiert und anschließend am Klotz 5 fixiert. Zur Fixierung wird die metallisierte Glasfaser 8 flußmittelfrei auf dem als Auflageblock dienenden Klotz 5 verlötet. Die Haltewinkel 1 und 1' werden vorzugsweise durch Schweißen mit dem Schaltungsmodul 13 verbunden. Auf diese Weise läßt sich sicherstellen, daß beim Fixieren der Glasfaser 8 auf dem Klotz 5, das insbesondere durch Löten mittels Heißgas vorgenommen wird, die Verbindung des Diodenträgers 3 mit dem Schaltungsmodul 13 mit der gewünschten Exaktheit erhalten bleibt.

Für die elektrischen Eigenschaften der Empfangsvorrichtung kann es vorteilhaft sein, auf dem Diodenträger zusätzlich zur Diode 2 elektrische Schaltmittel anzuordnen, die eine besonders günstige elektrische Schnittstelle zwischen Diodenträger 3 und Schaltungsmodul 13 ermöglichen. Solche Schaltmittel können insbesondere ein Feldeffekttransistor mit Vorwiderstand in der Gate-Zuleitung sein, der mit seinem Gate an der Anode der Diode 2 angeschlossen ist. In diesem Fall werden für die elektrische Verbindung mit dem Schaltungsmodul vier elektrische Verbindungen benötigt, nämlich eine für den Gate-Vorwiderstand, zwei weitere für den Drain- und für den Source-Anschluß des Feldeffekttransistors und die vierte für die Kathode der Diode 2.

In diesem Fall werden zweckmäßigerweise wenigstens zwei Haltewinkel geschweißt. Die weiteren Haltewinkel können mit dem Schaltungsmodul 13 durch Löten verbunden werden.

Nach der Fixierung des Lichtwellenleiters auf dem Klotz 5 wird das in Fig. 1 gezeigte Verbindungsstück 7 mit dem Rohr 10 und der von der Stirnseite bis über das Verbindungsstück 9 hinaus metallisierten Glasfaser 8 durch Löten verbunden. Die Stirnseite der Glasfaser 8 ist vorzugsweise eine nach dem Metallisiervorgang hergestellte Bruchstelle, gegebenenfalls mit üblicher Nachbearbeitung.

Die in den Figuren dargestellte Empfangsvorrichtung enthält eine PIN-Fotodiode als Empfangsdiode. Bei einer Sendevorrichtung tritt an die Stelle der Empfangsdiode als Sendediode beispielsweise eine Laserdiode oder lichtemittierende Diode.

**Patentansprüche**

1. Sende- oder Empfangsvorrichtung mit einer mittels eines Trägers (3) gehalterten Sende- oder Empfangs-Diode (2) und mit einem mit einem optischen Fenster der Diode (2) optisch gekoppelten Lichtwellenleiter (8), wobei der Träger (3) mit einer Ausnehmung (31) zur Durchführung des Lichtwellenleiters (8) versehen ist und die Diode (2) derart auf den Träger (3) aufgesetzt ist, daß sich das optische Fenster (20) der Diode (2) an der Ausnehmung (31) befindet, dadurch gekennzeichnet, daß der Träger (3) mit einem Schaltungsmodul (13) mechanisch verbunden ist und daß der Lichtwellenleiter (8) über eine ebenfalls auf dem Schaltungsmodul (13) angebrachte Fixiervorrichtung (5) und durch die Ausnehmung (31) an das optische Fenster (20) geführt und derart fixiert ist, daß die Stirnseite (80) des Lichtwellenleiters (8) einen vorgegebenen Abstand vom optischen Fenster (20) aufweist und daß die Ausnehmung (31) konisch ausgebildet ist und daß sich die Diode (2) auf derjenigen Seite des Trägers (3) befindet, die die größere der beiden Stirnflächen der konischen Ausnehmung (31) aufweist.

2. Sende- oder Empfangsvorrichtung nach Anspruch 1, dadurch gekennzeichnet, daß der Träger (3) quaderförmig, insbesondere plattenförmig ausgebildet und senkrecht auf einer Grundplatte des Schaltungsmoduls (13) befestigt ist und daß die Grundplatte (13) auf der der Diode (2) abgewandten Seite des Trägers (3) einen die Fixiervorrichtung (5) bildenden Klotz trägt, auf dem der Lichtwellenleiter (8) mittels einer flußmittelfreien Lötverbindung (4) fixiert ist.

3. Sende- oder Empfangsvorrichtung nach Anspruch 2 dadurch gekennzeichnet, daß der Lichtwellenleiter (8) auf optimale Lichteinkopplung in Diode (2) justiert und auf der Fixiervorrichtung (5) fixiert ist.

4. Sende- oder Empfangsvorrichtung nach einem der Ansprüche 1 bis 3, dadurch gekennzeichnet, daß die Ausnehmung (31) durch eine mittels Laserstrahlen hergestellte Bohrung erhalten ist.

5. Sende- oder Empfangsvorrichtung nach einem der Ansprüche 1 bis 4, dadurch gekennzeichnet, daß die Diode (2) eine ringförmige Kathoden-Anschlußfläche (21) aufweist, die ein kreisflächenförmiges optisches Fenster (20) umschließt und dem optischen Fenster (20) gegenüberliegend eine Anoden-Anschlußfläche hat, und daß die Kathoden-Anschlußfläche (21) mittels eines elektrisch leitenden Klebers (21) mit einem auf dem Träger (3) befindlichen elektrischen Leiter (33) verbunden ist und daß die Anoden-Anschlußfläche (22) durch eine Bondverbindung (23) mit einem weiteren auf dem Träger (3) befindlichen elektrischen Leiter (32) verbunden ist.

6. Sende- oder Empfangsvorrichtung nach Anspruch 4, dadurch gekennzeichnet, daß zur mechanischen Verbindung des Trägers (3) mit dem Schaltungsmodul (13) vorgesehene Haltewinkel (1) aus elektrisch leitendem Material bestehen und sowohl mit den elektrischen Leitern (31, 32) des Trägers (3) als auch mit elektrischen Leitern des Schaltungsmoduls (13) elektrisch verbunden sind.

7. Sende- oder Empfangsvorrichtung nach einem der Ansprüche 1 bis 6, dadurch gekennzeichnet, daß die Glasfaser (8) in der Ausnehmung (15) unbefestigt ist.

8. Verfahren zur Herstellung einer Sende- oder Empfangsvorrichtung nach einem der vorhergehenden Ansprüche, dadurch gekennzeichnet, daß die Glasfaser (8) mit Hilfe eines zwischen dem Träger (3) und dem Klotz (5) angreifenden Mikromanipulators justiert und daran anschließend am Klotz (5) fixiert wird.

## Claims

1. A transmitting or receiving device comprising a transmitting or receiving diode (2) which is supported by means of a carrier (3) and comprising a light guide (8) which is optically coupled to an optical window of the diode (2), where the carrier (3) is provided with a recess (31) for the light guide (8) to pass through and the diode (2) is placed onto the carrier (3) in such a manner that the optical window (20) of the diode (2) is arranged against the recess (31), characterised in that the carrier (3) is mechanically connected to a switching module (13) and that the light guide (8) is guided through the recess (31) to the optical window (20) by means of a fixing device (5), which is likewise arranged on the switching module (13), and is fixed to be such that the front (80) of the light guide (8) has a predetermined spacing from the optical window (20), and that the recess (31) is conical and that the diode (2) is arranged on the side of the carrier (3) which has the larger of the two end faces of the conical recess (31).

2. A transmitting and receiving device as claimed in claim 1, characterised in that the carrier (3) is shaped like a parallepiped, in particular of plate shape, and is vertically secured on a base plate of the switching module (13), and that on the side of the carrier (3) facing away from the diode (2) the base plate (13) supports a block which forms the fixing device (5) and on which the light guide (8) is fixed by means of a flux-free soldered connection (4).

3. A transmitting or receiving device as claimed in claim 2, characterised in that the light guide (8) is adjusted to the optimal light input coupling with diode (2) and is fixed on the fixing device (5).

4. A transmitting or receiving device as claimed in one of claims 1 to 3, characterised in that the recess (31) is a bore which is formed by means of laser beams.

5. A transmitting or receiving device as claimed in one of claims 1 to 4, characterised in that the diode (2) has an annular cathode terminal surface (21) which surrounds a circular optical window (20) and has an anode terminal surface opposite the optical window (20), and that the cathode terminal surface (21) is connected to an electrical conductor (33) arranged on the carrier (3), by means of an electrically conductive adhesive (21) and that the anode terminal surface (22) is connected to a further electrical conductor (32) arranged on the carrier (3), by means of a bonding connection (23).

6. A transmitting or receiving device as claimed in claim 4, characterised in that holding brackets (1) which are provided for the mechanical connection of the carrier (3) to the switching module (3) comprise an electrically conductive material and are electrically connected both to the electrical conductors (31, 32) of the carrier (3) and also to the electrical conductors of the switching module (13).

7. A transmitting or receiving device as claimed in one of claims 1 to 6, characterised in that the glass fibre (8) is not fixed in the recess (15).

8. A process for the production of a transmitting or receiving device as claimed in one of the preceding claims, characterised in that the glass fibre (8) is adjusted with the aid of a micromanipulator, which acts between the carrier (3) and the block (5), and is subsequently fixed on the block.

## Revendications

1. Dispositif émetteur ou récepteur, avec une diode émettrice ou réceptrice (2) maintenue à l'aide d'un support (3), avec un guide d'ondes de lumière (8) couplé optiquement avec une fenêtre optique de la diode (2), ledit support (3) étant pourvu d'une ouverture (31) pour le passage du guide d'ondes de lumière (8) et la diode (2) étant montée de telle façon sur le support (3) que la fenêtre optique (20) de la diode (2) se trouve au droit de l'ouverture (31), caractérisé par le fait que le support (3) est relié mécaniquement à un module de circuit (13) et que le guide d'ondes de lumière (8) est passé par un dispositif de fixation (5) également prévu sur le module de circuit (13) ainsi que par l'ouverture (31) jusqu'à la fenêtre optique (20) et est fixé de telle façon que le côté frontal (80) du guide d'ondes de lumière (8) est à une distance prédéterminée de la fenêtre optique (20), et que l'ouverture (31) est conique, et que la diode (2) se situe du côté du support (3) qui possède la plus grande des deux surfaces frontales de l'ouverture conique (31).

2. Dispositif émetteur ou récepteur selon la revendication 1, caractérisé par le fait que le support (3) a la forme d'un parallélépipède, en particulier a la forme d'une plaque et est fixé en position perpendiculaire sur une plaque de base du module de circuit (13), et que la plaque de base (13) porte, sur le côté éloigné du support (3), un sabot qui constitue le dispositif de fixation (5), et sur lequel est fixé le guide d'ondes de lumière (8) à l'aide d'une liaison par soudure (4) dépourvue de flux.

3. Dispositif émetteur ou récepteur selon la revendication 2, caractérisé par le fait que le guide d'ondes de lumière (8) est ajusté pour un passage optimal de la lumière dans la diode (2), et il est fixé sur le dispositif de fixation (5).

4. Dispositif émetteur ou récepteur selon l'une des revendications 1 à 3, caractérisé par le fait que l'ouverture (31) est obtenue par un perçage réalisé à l'aide de rayons laser.

5. Dispositif émetteur ou récepteur selon l'une des revendications 1 à 4, caractérisé par le fait que la diode (2) présente une surface de raccordement cathodique annulaire (21) qui entoure une fenêtre optique (20) ayant la forme d'une surface circulaire et présente, en face de la fenêtre optique (20), une surface de raccordement anodique, et que la surface de raccordement cathodique (21) est reliée, à l'aide d'une colle électriquement conductrice (21), avec un conducteur électrique (33) qui se trouve sur le support (3), et que la surface de raccordement anodique (22) est reliée, par une liaison par bonding (23), avec un autre conducteur électrique (32) qui se trouve sur le support (3).

6. Dispositif émetteur ou récepteur selon la revendication 4, caractérisé par le fait que pour la liaison mécanique du support (3) avec le module de circuit (13), on a prévu des équerres (1) qui sont constituées avec un matériau électriquement conducteur et qui sont reliées électriquement aussi bien avec les conducteurs électriques (31, 32) du support (3) qu'avec des conducteurs électriques du module de circuit (13).

7. Dispositif émetteur ou récepteur selon l'une des revendications 1 à 6, caractérisé par le fait que la fibre de verre (8) n'est pas fixée dans l'ouverture (15).

8. Procédé pour la réalisation d'un dispositif émetteur ou récepteur selon l'une des revendications précédentes, caractérisé par le fait que la fibre de verre (8) est ajustée à l'aide d'un micromanipulateur dont le point d'attaque est situé entre le support (3) et le sabot (5), et est ensuite fixée sur le sabot (5).

# FIG 1

0 111 263

## FIG 2

0 111 263

# FIG 3

# FIG 4

# FIG 5